# EUROPÄISCHE PATENTSCHRIFT

(11) **EP 4 165 452 B1**
(45) Veröffentlichungstag und Bekanntmachung des Hinweises auf die Patenterteilung: **25.11.2026**
(21) Anmeldenummer: 21762468.3
(22) Anmeldetag: 16.08.2021
(51) Int. Cl.: G02B 6/24, G02B 6/26, G02B 6/38, G01R 15/24, G01R 33/032, G02B 6/024, G02B 6/255

(54) **LICHTLEITER FÜR EINEN MAGNETOOPTISCHEN STROMSENSOR**
OPTICAL WAVEGUIDE FOR A MAGNETO-OPTICAL CURRENT SENSOR
GUIDE D'ONDES OPTIQUE POUR CAPTEUR DE COURANT MAGNÉTO-OPTIQUE

(30) Priorität: 31.08.2020 DE 102020210949
(43) Veröffentlichungstag der Anmeldung: 19.04.2023
(73) Patentinhaber: HSP Hochspannungsgeräte GmbH, 53842 Troisdorf (DE)
(72) Erfinder: JUDENDORFER, Thomas, 96050 Bamberg (DE); SCHUBERTH, Stefan, 96215 Lichtenfels-Schney (DE)
(74) Vertreter: Betten & Resch
(86) Internationale Anmeldenummer: PCT/EP2021/072730
(87) Internationale Veröffentlichungsnummer: WO 2022/043113

(56) Entgegenhaltungen:
- DE-A1- 10 259 390
- DE-A1- 4 342 410
- US-A- 6 128 423
- US-A1- 2006 103 380
- US-A1- 2009 214 152

## Beschreibung

Die Erfindung betrifft einen Lichtleiter für einen magnetooptischen Stromsensor und einen magnetooptischen Stromsensor mit einem derartigen Lichtleiter.

Unter einem magnetooptischen Stromsensor mit einem Lichtleiter wird hier eine optische Messvorrichtung zum Messen eines elektrischen Stroms in einem Stromleiter verstanden, bei dem Licht durch den Lichtleiter geführt wird und in dem Lichtleiter durch ein von dem Strom erzeugtes Magnetfeld in seinen optischen Eigenschaften verändert wird. Beispielsweise beruht ein magnetooptischer Stromsensor auf dem magnetooptischen Faraday-Effekt. Unter dem Faraday-Effekt versteht man die Drehung der Polarisationsrichtung einer linear polarisierten elektromagnetischen Welle in einem Medium durch ein zur Ausbreitungsrichtung der Welle paralleles Magnetfeld. Die Drehung der Polarisationsrichtung ist dabei proportional zu der magnetischen Flussdichte des Magnetfelds.

Bei einem auf dem Faraday-Effekt beruhenden magnetooptischen Stromsensor wird linear polarisiertes Licht durch einen in der Nähe des Stromleiters angeordneten Lichtleiter geleitet, der den Faraday-Effekt zeigt. Das von dem Strom in dem Stromleiter erzeugte Magnetfeld bewirkt in dem Lichtleiter eine Drehung der Polarisationsrichtung des Lichts. Da die magnetische Flussdichte des Magnetfelds in dem Lichtleiter von der Stromstärke des Stroms in dem Stromleiter abhängt, lässt sich die Stromstärke messen, indem die Drehung der Polarisationsrichtung des Lichts in dem Lichtleiter erfasst wird. Um die Drehung der Polarisationsrichtung zu erfassen, wird das von dem Lichtleiter ausgegebene Licht beispielsweise durch einen ausgangsseitigen Polarisator geführt und es wird eine Lichtintensität des von dem Polarisator transmittierten Lichts erfasst.

Die Lichtintensität des Lichts, das in den Lichtleiter eines magnetooptischen Stromsensors eingekoppelt wird, ist aufgrund von optischen Eigenschaften des Lichtleiters und/oder der verwendeten Lichtquelle jedoch limitiert. Ferner ist die Lichtintensität des Lichts, das von dem Lichtleiter ausgegeben wird, im Vergleich zur Lichtintensität des in den Lichtleiter eingekoppelten Lichts durch Streuung, Absorption und Reflexion von Licht reduziert. Die Lichtintensität des von dem Lichtleiter ausgegebenen Lichts wird beispielsweise mit einer Fotodiode bestimmt. Fotdioden weisen ein Grundrauschen auf, das sich aus verschiedensten Rauschquellen zusammensetzt. Eine sehr geringe von dem Lichtleiter ausgegebene Lichtintensität führt zu einem geringen Signal-Rausch-Verhältnis des Messsignals und limitiert daher die Genauigkeit der Messung der Lichtintensität.

Eine Erhöhung der Lichtintensität des in den Lichtleiter eingekoppelten Lichts durch Verwendung einer lichtstärkeren Lichtquelle ist häufig aus unterschiedlichen Gründen nicht möglich oder nicht vorteilhaft. Beispielsweise kann die Lichtintensität durch Verwendung eines geeigneten Halbleiterlasers als Lichtquelle zwar erhöht werden. Jedoch steigt dabei durch die erhöhte Kohärenzlänge des Lichts die Vibrationsempfindlichkeit des magnetooptischen Stromsensors stark an. Auch einer Verbesserung des Signal-Rausch-Verhältnisses des Messsignals durch eine entsprechende Filterung des Messsignals, die die Bandbreite des resultierenden Messsignals reduziert, sind Grenzen gesetzt, da die Reduzierung der Bandbreite die Zeitauflösung des Messsignals reduziert.

Aus der DE 102 59 390 A1 ist ein faseroptischer Lichtwellenleiter bekannt, der mit Erbium-dotierten Zwischenstücken versehen ist. Zwischen den Zwischenstücken und weiteren Teilen des Lichtwellenleiters können Antireflexbeschichtungen vorhanden sein. Aus der US 6 128 423 A ist ein magnetooptischer Sensor bekannt, bei dem faseroptische Lichtwellenleiter zur Anbindung des Sensors an eine Leuchtdiode mit einer Antireflexbeschichtung versehen sein können. Das Dokument US 2006/103380 A1 ist nachveröffentlicht gemäß Artikel 54(3) EPÜ und offenbart einen magnetoptischen Wellenleiter-Sensor, der ein Signal bereitstellt, das den Wert und/oder die Richtung eines erfassten Magnetfelds durch eine spektrale Verschiebung des charakteristischen resonanten Spektralmerkmals des Sensors anzeigt. DE 43 42 410 A1 offenbart ein Verfahren zur magnetooptischen Strommessung und magnetooptische Strommesseinrichtung mit einem magnetooptischen Stromsensor aus Quarz, der mehrere spiegelnde Seitenflächen und in seinem Inneren eine Aussparung und darin einen Stromleiter aufweist.

Der Erfindung liegt die Aufgabe zugrunde, die Lichtintensität des von einem Lichtleiter eines magnetooptischen Stromsensors ausgegebenen Lichts zu erhöhen.

Die Aufgabe wird erfindungsgemäß durch einen Lichtleiter mit den Merkmalen des Anspruchs 1 und einen magnetooptischen Stromsensor mit den Merkmalen des Anspruchs 5 gelöst. Vorteilhafte Ausgestaltungen der Erfindung sind Gegenstand der Unteransprüche.

Ein Lichtleiter für einen magnetooptischen Stromsensor umfasst eine erste Endfläche, durch die Licht in den Lichtleiter einkoppelbar ist, und eine zweite Endfläche, durch die Licht aus dem Lichtleiter auskoppelbar ist, wobei wenigstens eine der beiden Endflächen eine Antireflexbeschichtung aufweist und wobei der Lichtleiter wenigstens abschnittsweise aus Glas gefertigt und nicht als faseroptischer Lichtwellenleiter ausgebildet ist.

Durch eine Antireflexbeschichtung wird die Reflexion von Licht an einer Endfläche des Lichtleiters reduziert und damit die Transmission von Licht durch die Endfläche erhöht. Wenn die Endfläche, durch die Licht in den Lichtleiter eingekoppelt wird, mit einer Antireflexbeschichtung versehen wird, kann die Lichtintensität des in den Lichtleiter eingekoppelten Lichts um etwa 10 bis 20 Prozent gegenüber einer Ausführung des Lichtleiters ohne diese Antireflexbeschichtung erhöht werden. Wenn die Endfläche, durch die Licht aus dem Lichtleiter ausgekoppelt wird, mit einer Antireflexbeschichtung versehen wird, kann die Lichtintensität des aus dem Lichtleiter ausgekoppelten Lichts um etwa 10 bis 20 Prozent gegenüber einer Ausführung des Lichtleiters ohne diese Antireflexbeschichtung erhöht werden. Ferner reduziert eine Antireflexbeschichtung der Endfläche, durch die Licht aus dem

Lichtleiter ausgekoppelt wird, auch vorteilhaft Reflexionen von Licht an dieser Endfläche, die Licht zurück in den Lichtleiter reflektieren.

Eine Ausgestaltung des Lichtleiters weist wenigstens eine Antireflexionsschicht auf, die zwischen zwei Lichtleiterabschnitten mit voneinander verschiedenen Brechungsindizes angeordnet ist. An einer Grenzschicht zwischen zwei Lichtleiterabschnitten mit voneinander verschiedenen Brechungsindizes wird ein Teil des Lichts, das auf die Grenzschicht trifft, reflektiert. Dadurch werden die Transmission von Licht durch die Grenzschicht und die Lichtintensität des von dem Lichtleiter ausgegebenen Lichts reduziert. Außerdem wird Licht in dem Lichtleiter in die einer vorgesehenen Durchgangsrichtung entgegengesetzte Richtung zurückreflektiert. Die Antireflexionsschicht zwischen den beiden Lichtleiterabschnitten reduziert vorteilhaft die Reflexionen von Licht zwischen den Lichtleiterabschnitten und erhöht dadurch die Lichtintensität des von dem Lichtleiter ausgegebenen Lichts gegenüber einer Ausführung des Lichtleiters ohne die Antireflexionsschicht.

Der Lichtleiter ist wenigstens abschnittsweise aus Glas, beispielsweise aus optischem Flintglas, gefertigt. Wenn der Lichtleiter Lichtleiterabschnitte aufweist, die aus verschiedenen Gläsern mit voneinander verschiedenen Brechungsindizes gefertigt sind, wird entsprechend der vorgenannten Ausgestaltung des Lichtleiters vorzugsweise zwischen zwei benachbarten derartigen Lichtleiterabschnitten eine Antireflexionsschicht angeordnet. Alternativ oder zusätzlich kann zwischen zwei derartigen Lichtleiterabschnitten eine Klebeschicht angeordnet werden, durch die die beiden Lichtleiterabschnitte miteinander verklebt sind, wobei die Klebeschicht einen Brechungsindex aufweist, der zwischen den Brechungsindizes der beiden Lichtleiterabschnitte liegt. Die Fertigung des Lichtleiters aus Glas hat beispielsweise gegenüber der Verwendung faseroptischer Lichtleiter den Vorteil, dass keine teueren Lichtwellenleiter als Lichtleiter verwendet werden müssen, die eine lineare Polarisation des Lichts aufrecht erhalten. Eine Klebeschicht zwischen zwei Lichtleiterabschnitten aus Gläsern mit voneinander verschiedenen Brechungsindizes reduziert ebenfalls vorteilhaft Reflexionen an einer Grenzschicht zwischen den Lichtleiterabschnitten, wenn die Klebeschicht einen Brechungsindex aufweist, der zwischen den Brechungsindizes der beiden Lichtleiterabschnitte liegt.

Bei einer Ausgestaltung eines nicht zur Erfindung gehörenden Lichtleiters ist der Lichtleiter wenigstens abschnittsweise als faseroptischer Lichtwellenleiter ausgebildet. Wenn der Lichtleiter Lichtleiterabschnitte aufweist, die als voneinander verschiedene faseroptische Lichtwellenleiter mit voneinander verschiedenen Brechungsindizes ausgebildet sind, wird entsprechend der oben bereits genannten Ausgestaltung des erfindungsgemäßen Lichtleiters vorzugsweise zwischen zwei benachbarten derartigen Lichtleiterabschnitten eine Antireflexionsschicht angeordnet. Eine Endfläche, die eine Antireflexbeschichtung aufweist, ist in dem Fall eines durch einen oder mehrere faseroptische Lichtwellenleiter gebildeten Lichtleiters beispielsweise eine Stirnfläche eines faseroptischen Lichtwellenleiters oder eine Stirnfläche einer Ferrule eines faseroptischen Lichtwellenleiters.

Ein magnetooptischer Stromsensor zum Erfassen einer Stromstärke eines elektrischen Stroms in einem Stromleiter umfasst wenigstens einen im Bereich des Stromleiters angeordneten Lichtleiter.

Die Vorteile eines magnetooptischen Stromsensors entsprechen den oben genannten Vorteilen eines Lichtleiters.

Bei einer Ausgestaltung des magnetooptischen Stromsensors verläuft wenigstens ein Lichtleiter ringförmig um den Stromleiter herum. Dadurch wird die Messung der Stromstärke des Stroms im Stromleiter weitgehend unabhängig von der Position des Stromleiters relativ zu dem Lichtleiter und der Einfluss äußerer Felder auf die Messung wird reduziert.

Die Erfindung wird im Zusammenhang mit den Zeichnungen näher erläutert. Dabei zeigen:
- FIG 1: ein erstes Ausführungsbeispiel eines magnetooptischen Stromsensors,
- FIG 2: einen Ausschnitt eines Lichtleiters mit zwei Lichtleiterabschnitten und einer Klebeschicht,
- FIG 3: ein Ausführungsbeispiel eines nicht zur Erfindung gehörenden magnetooptischen Stromsensors,
- FIG 4: einen Ausschnitt eines Lichtleiters mit zwei Lichtleiterabschnitten und einer Antireflexionsschicht.

Einander entsprechende Teile sind in den Figuren mit denselben Bezugszeichen versehen.

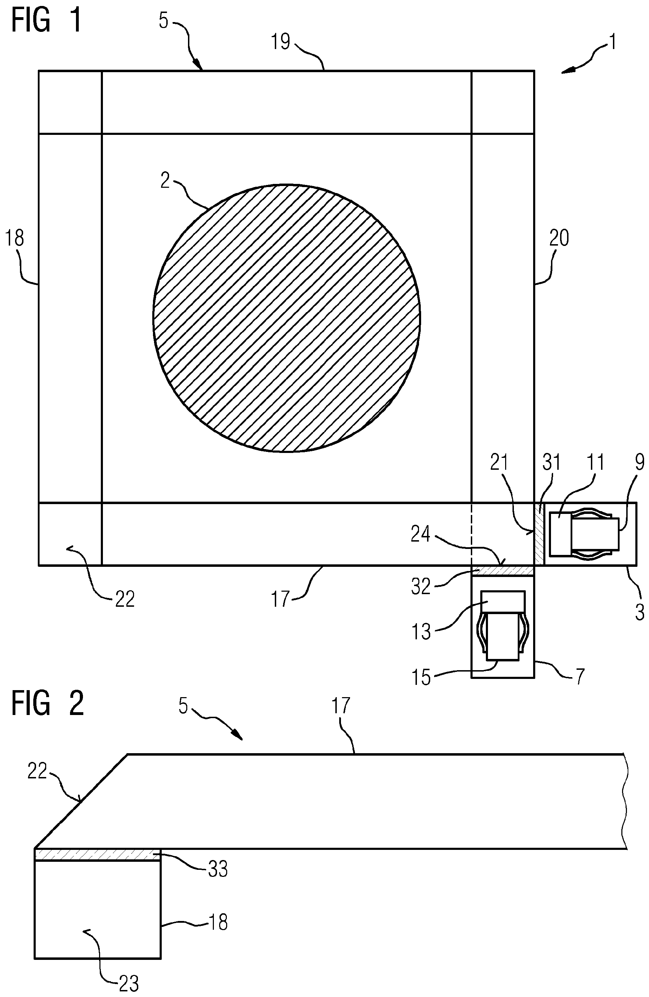

Figur 1 (FIG 1) zeigt ein erstes Ausführungsbeispiel eines magnetooptischen Stromsensors 1 zum Erfassen einer Stromstärke eines elektrischen Stroms in einem Stromleiter 2. Der Stromwandler 1 umfasst eine Lichteinkopplungseinheit 3, ein erstes Ausführungsbeispiel eines Lichtleiters 5 und eine Lichtauskopplungseinheit 7.

Die Lichteinkopplungseinheit 3 weist einen Eingangskollimator 9 und einen linearen Eingangspolarisator 11 auf. Der Eingangskollimator 9 ist eingerichtet, Licht einer (nicht dargestellten) Lichtquelle, beispielsweise einer Leuchtdiode, zu bündeln. Der Eingangspolarisator 11 polarisiert Licht, so dass dem Lichtleiter 5 linear polarisiertes Licht zugeführt wird.

Der Lichtleiter 5 ist eingerichtet, ihm von der Lichteinkopplungseinheit 3 zugeführtes Licht der Lichtauskopplungseinheit 7 zuzuführen. Der Lichtleiter 5 zeigt den Faraday-Effekt. Wenn ein Strom in dem Stromleiter 2 fließt, wird die Polarisationsrichtung des Lichts während des Durchlaufens des Lichtleiters 5 aufgrund des Faraday-Effekts gedreht.

Die Lichtauskopplungseinheit 7 weist einen Ausgangspolarisator 13 und einen linearen Ausgangskollimator 15 auf. Von dem Ausgangspolarisator 13 wird ein Anteil des von dem Lichtleiter 5 ausgegebenen Lichts transmittiert, der parallel zu einer Polarisationsachse des Ausgangspolarisators 13 ist. Der Ausgangskollimator 15 bündelt das von dem Ausgangspolarisator 13 transmittierte Licht und führt es einem (nicht dargestellten) Photodetektor zu. Der Photodetektor ist eingerichtet, die Lichtintensität des ihm zugeführten Lichts zu erfassen. Beispielsweise ist der Photodetektor als eine Fotodiode ausgebildet. Anhand der von dem Photodetektor erfassten Lichtintensität wird die Stromstärke des elektrischen Stroms durch den Stromleiter 2 bestimmt.

Der Lichtleiter 5 dieses Ausführungsbeispiels ist als ein Glasring ausgebildet, der ringförmig um den Stromleiter 2 herum verläuft. Der Stromleiter 2 verläuft orthogonal zu der Zeichenebene der Figur 1. Der Lichtleiter 5 wird von vier Lichtleiterabschnitten 17 bis 20 gebildet, die jeweils als ein Prismatoid aus Glas ausgebildet sind. Ein erster Lichtleiterabschnitt 17 verläuft von der Lichteinkopplungseinheit 3 zu einem zweiten Lichtleiterabschnitt 18. Der zweite Lichtleiterabschnitt 18 verläuft zwischen dem ersten Lichtleiterabschnitt 17 und einem dritten Lichtleiterabschnitt 19. Der dritte Lichtleiterabschnitt 19 verläuft zwischen dem zweiten Lichtleiterabschnitt 18 und dem vierten Lichtleiterabschnitt 20. Der vierte Lichtleiterabschnitt 20 verläuft von dem dritten Lichtleiterabschnitt 19 zu der Lichtauskopplungseinheit 7. Eine Längsachse des ersten Lichtleiterabschnitts 17 ist orthogonal zu Längsachsen des zweiten Lichtleiterabschnitts 18 und des vierten Lichtleiterabschnitts 20 und parallel zu einer Längsachse des dritten Lichtleiterabschnitts 19.

Eine der Lichteinkopplungseinheit 3 zugewandte Endfläche 21 des ersten Lichtleiterabschnitts 17, die orthogonal zu der Zeichenebene der Figur 1 ist, weist eine erste Antireflexbeschichtung 31 auf. Eine dieser Endfläche 21 gegenüberliegende Endfläche 22 des ersten Lichtleiterabschnitts 17 ist gegenüber der Zeichenebene der Figur 1 um 45 Grad gekippt (siehe dazu auch Figur 2). An der Endfläche 22 wird Licht, das entlang der Längsachse des ersten Lichtleiterabschnitts 17 den ersten Lichtleiterabschnitt 17 durchläuft, zu dem zweiten Lichtleiterabschnitt 18 hin totalreflektiert. In dem zweiten Lichtleiterabschnitt 18 trifft das Licht auf eine Endfläche 23 (siehe Figur 2) des zweiten Lichtleiterabschnitts 18, die ebenfalls um 45 Grad gegenüber der Zeichenebene der Figur 1 gekippt ist und Licht durch Totalreflexion parallel zu der Längsachse des zweiten Lichtleiterabschnitts 18 umlenkt. Entsprechend wird das Licht von dem zweiten Lichtleiterabschnitt 18 zu dem dritten Lichtleiterabschnitt 19 und von dem dritten Lichtleiterabschnitt 19 zu dem vierten Lichtleiterabschnitt 20 gelenkt. Eine der Lichtauskopplungseinheit 7 zugewandte Endfläche 24 des vierten Lichtleiterabschnitts 20, die orthogonal zu der Zeichenebene der Figur 1 ist, weist eine zweite Antireflexbeschichtung 32 auf.

Die erste Antireflexbeschichtung 31 erhöht die Lichtintensität des in den Lichtleiter 5 eingekoppelten Lichts um etwa 10 bis 20 Prozent gegenüber einer Ausführung des Lichtleiters 5 ohne die erste Antireflexbeschichtung 31. Die zweite Antireflexbeschichtung 32 erhöht die Lichtintensität des aus dem Lichtleiter 5 ausgekoppelten Lichts um etwa 10 bis 20 Prozent gegenüber einer Ausführung des Lichtleiters 5 ohne die zweite Antireflexbeschichtung 32. Ferner reduziert die zweite Antireflexbeschichtung 32 Reflexionen von Licht an der Endfläche 24, die Licht zurück in den Lichtleiter 5 reflektieren.

Figur 2 (FIG 2) zeigt einen analog zu Figur 1 ausgeführten Lichtleiter 5 in einem Bereich, in dem der erste Lichtleiterabschnitt 17 an den zweiten Lichtleiterabschnitt 18 grenzt. In diesem Beispiel sind der erste Lichtleiterabschnitt 17 und der zweite Lichtleiterabschnitt 18 aus voneinander verschiedenen Gläsern gefertigt, die voneinander verschiedene Brechungsindizes aufweisen. Der erste Lichtleiterabschnitt 17 und der zweite Lichtleiterabschnitt 18 sind durch eine Klebeschicht 33 miteinander verklebt, die einen Brechungsindex aufweist, der zwischen den Brechungsindizes der beiden Lichtleiterabschnitte 17, 18 liegt. Dadurch werden vorteilhaft Reflexionen von Licht beim Übertritt von dem ersten Lichtleiterabschnitt 17 in den zweiten Lichtleiterabschnitt 18 gegenüber einer Ausführung des Lichtleiters 5 ohne die Klebeschicht 33 reduziert.

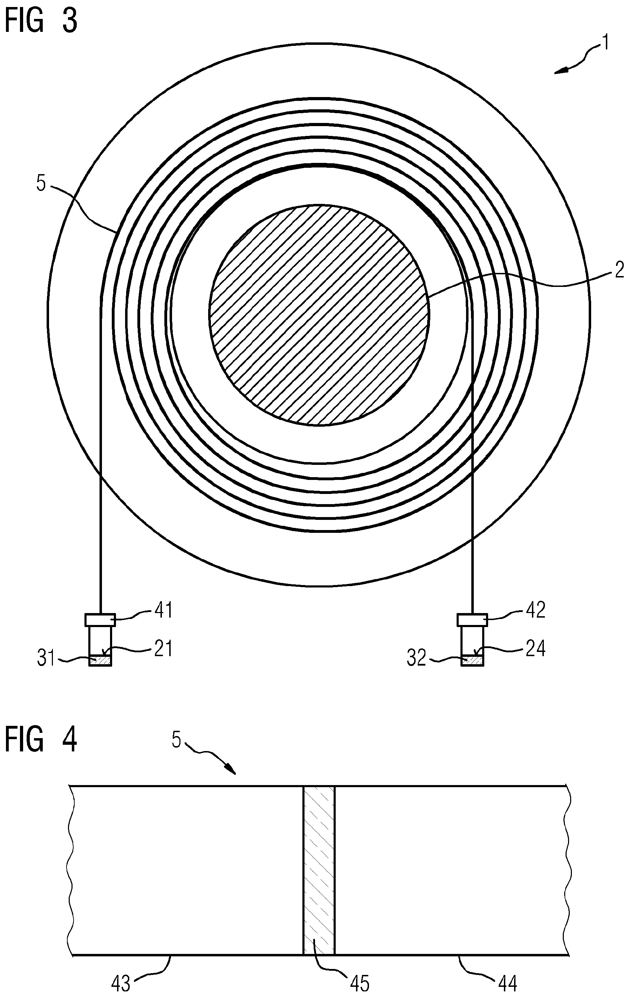

Figur 3 (FIG 3) zeigt ein Ausführungsbeispiel eines nicht zur Erfindung gehörenden magnetooptischen Stromsensors 1 zum Erfassen einer Stromstärke eines elektrischen Stroms in einem Stromleiter 2. Die Darstellung erfolgt lediglich zur besseren Erläuterung der Erfindung. Dieses nicht zur Erfindung gehörende Ausführungsbeispiel weist einen Lichtleiter 5 auf, der als ein faseroptischer Lichtwellenleiter ausgebildet ist und mit einer Mehrzahl von Windungen ringförmig um den Stromleiter 2 verläuft. Die Enden des Lichtleiters 5 weisen jeweils eine Ferrule 41, 42 auf. Jede Ferrule 41, 42 weist eine Endfläche 21, 24 mit einer Antireflexbeschichtung 31, 32 auf.

Figur 4 (FIG 4) zeigt einen Ausschnitt eines Lichtleiters 5 für einen magnetooptischen Stromsensor 1, der Lichtleiterabschnitte 43, 44 mit voneinander voneinander verschiedenen Brechungsindizes aufweist. Beispielsweise sind die Lichtleiterabschnitte 43, 44 aus voneinander verschiedenen Gläsern gefertigt. Zwischen zwei aneinander grenzenden Lichtleiterabschnitten 43, 44 ist eine Antireflexionsschicht 45 angeordnet, die Reflexionen von Licht beim Übertritt von Licht zwischen den Lichtleiterabschnitten 43, 44 gegenüber einer Ausführung des Lichtleiters 5 ohne die Antireflexionsschicht 45 reduziert.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Die Erfindung wird durch die angehängten Patentansprüche definiert.

## Patentansprüche

1. Lichtleiter (5) für einen magnetooptischen Stromsensor (1), der Lichtleiter (5) umfassend
- eine erste Endfläche (21), durch die Licht in den Lichtleiter (5) einkoppelbar ist, und eine zweite Endfläche (24), durch die Licht aus dem Lichtleiter (5) auskoppelbar ist, wobei
- wenigstens eine der beiden Endflächen (21, 24) eine Antireflexbeschichtung (31, 32) aufweist,
wobei der Lichtleiter (5) als Glasring ausgebildet ist,
wobei der Lichtleiter (5) von vier Lichtleiterabschnitten (17-20) gebildet wird, die jeweils als ein Prismatoid aus Glas ausgebildet sind, wobei ein erster Lichtleiterabschnitt (17) der vier Lichtleiterabschnitte (17-20) die erste Endfläche (21) umfasst und zu einem zweiten Lichtleiterabschnitt (18) der vier Lichtleiterabschnitte (17-20) verläuft, der zweite Lichtleiterabschnitt (18) zwischen dem ersten Lichtleiterabschnitt (17) und einem dritten Lichtleiterabschnitt (19) der vier Lichtleiterabschnitte (17-20) verläuft, der dritte Lichtleiterabschnitt (19) zwischen dem zweiten Lichtleiterabschnitt (18) und einem vierten Lichtleiterabschnitt (20) der vier Lichtleiterabschnitte (17-20) verläuft, und der vierte Lichtleiterabschnitt (20) zwischen dem dritten Lichtleiterabschnitt (19) und dem ersten Lichtleiterabschnitt (17) verläuft und die zweite Endfläche (24) umfasst, und wobei eine Längsachse des ersten Lichtleiterabschnitts (17) orthogonal zu Längsachsen des zweiten Lichtleiterabschnitts (18) und des vierten Lichtleiterabschnitts (20) und parallel zu einer Längsachse des dritten Lichtleiterabschnitts (19) ist, und
wobei eine der ersten Endfläche (21) gegenüberliegende Endfläche (22) des ersten Lichtleiterabschnitts (17) um 45 Grad gekippt ist, um Licht, das entlang der Längsachse des ersten Lichtleiterabschnitts (17) den ersten Lichtleiterabschnitt (17) durchläuft, zu dem zweiten Lichtleiterabschnitt (18) hin total zu reflektieren, und wobei entsprechend das Licht von dem zweiten Lichtleiterabschnitt (18) zu dem dritten Lichtleiterabschnitt (19) durch eine um 45 Grad gekippte Endfläche (23) des zweiten Lichtleiterabschnitts (18) und entsprechend von dem dritten Lichtleiterabschnitt (19) zu dem vierten Lichtleiterabschnitt (20) durch Totalreflexion umgelenkt wird.

2. Lichtleiter (5) nach Anspruch 1, wobei das Glas optisches Flintglas ist.

3. Lichtleiter (5) nach einem der vorhergehenden Ansprüche, wobei wenigstens eine Antireflexionsschicht (31, 32) zwischen zwei Lichtleiterabschnitten (17 bis 20) angeordnet ist, die aus voneinander verschiedenen Gläsern mit voneinander verschiedenen Brechungsindizes gefertigt sind.

4. Lichtleiter (5) nach einem der vorhergehenden Ansprüche, mit wenigstens einer Klebeschicht (33), durch die zwei aus voneinander verschiedenen Gläsern gefertigte Lichtleiterabschnitte (17 bis 20) mit voneinander verschiedenen Brechungsindizes miteinander verklebt sind, wobei die Klebeschicht (33) einen Brechungsindex aufweist, der zwischen den Brechungsindizes der beiden Lichtleiterabschnitte (17 bis 20) liegt.

5. Magnetooptischer Stromsensor (1) zum Erfassen einer Stromstärke eines elektrischen Stroms in einem Stromleiter (2), der magnetooptische Stromsensor (1) umfassend wenigstens einen Lichtleiter (5) nach einem der vorhergehenden Ansprüche, wobei der wenigstens eine Lichtleiter ausgelegt ist, ringförmig um den Stromleiter (2) herum zu verlaufen.

## Claims

1. An optical waveguide (5) for a magnetooptical current sensor (1), the optical waveguide (5) comprising:
- a first end face (21), through which light can be coupled into the optical waveguide (5), and a second end face (24), through which light can be decoupled from the optical waveguide (5),
wherein
- at least one of the two end faces (21, 24) has an antireflective coating (31, 32),
wherein the optical waveguide (5) is formed as a glass ring,
wherein the optical waveguide (5) is formed by four optical waveguide sections (17-20), which are each formed as a prismatoid from glass, wherein a first optical waveguide section (17) of the four optical waveguide sections (17-20) comprises the first end face (21) and extends to a second optical waveguide section (18) of the four optical waveguide sections (17-20), the second optical waveguide section (18) extends between the first optical waveguide section (17) and a third optical waveguide section (19) of the four optical waveguide sections (17-20), the third optical waveguide section (19) extends between the second optical waveguide section (18) and a fourth optical waveguide section (20) of the four optical waveguide sections (17-20), and the fourth optical waveguide section (20) extends between the third optical waveguide section (19) and the first optical waveguide section (17) and comprises the second end face (24), and
wherein a longitudinal axis of the first optical waveguide section (17) is orthogonal to longitudinal axes of the second optical waveguide section (18) and the fourth optical waveguide section (20) and parallel to a longitudinal axis of the third optical waveguide section (19), and
wherein an end face (22) of the first optical waveguide section (17) opposite to the first end face (21) is tilted by 45 degrees to totally reflect, toward the second optical waveguide section (18), light which runs through the first optical waveguide section (17) along the longitudinal axis of the first optical waveguide section (17), and wherein the light is correspondingly redirected from the second optical waveguide section (18) to the third optical waveguide section (19) by an end face (23), tilted by 45 degrees, of the second optical waveguide section (18) and correspondingly from the third optical waveguide section (19) to the fourth optical waveguide section (20) by total reflection.

2. The optical waveguide (5) according to claim 1, wherein the glass is optical flint glass.

3. The optical waveguide (5) according to any one of the preceding claims, wherein at least one antireflective layer (31, 32) is arranged between two optical waveguide sections (17 to 20), which are manufactured from glasses different from one another having indices of refraction different from one another.

4. The optical waveguide (5) according to any one of the preceding claims, comprising at least one adhesive layer (33), by which two optical waveguide sections (17 to 20) manufactured from glasses different from one another and having indices of refraction different from one another are adhesively bonded to one another, wherein the adhesive layer (33) has an index of refraction which is between the indices of refraction of the two optical waveguide sections (17 to 20).

5. A magnetooptical current sensor (1) for detecting an amperage of an electrical current in a current conductor (2), the magnetooptical current sensor (1) comprising at least one optical waveguide (5) according to any one of the preceding claims, wherein the at least one optical waveguide is adapted to extend in a ring shape around the current conductor (2).

## Revendications

1. Guide d'ondes optique (5) pour un capteur (1) de courant magnéto-optique, le guide d'ondes optique (5) comprenant
- une première face d'extrémité (21), par laquelle de la lumière peut être injectée dans le guide d'ondes optique (5), et une deuxième face d'extrémité (24), par laquelle la lumière peut être extraite du guide d'ondes optique (5), dans lequel
- au moins une des deux faces d'extrémité (21, 24) présente un revêtement antireflet (31, 32),
le guide d'ondes optique (5) étant réalisé sous la forme d'un anneau en verre,
le guide d'ondes optique (5) étant constitué par quatre sections (17 à 20) de guide d'ondes optique qui sont chacune réalisées sous la forme d'un prismatoïde en verre, une première section (17) de guide d'ondes optique parmi les quatre sections (17 à 20) de guide d'ondes optique comprenant la première face d'extrémité (21) et s'étendant jusqu'à une deuxième section (18) de guide d'ondes optique parmi les quatre sections (17 à 20) de guide d'ondes optique, la deuxième section (18) de guide d'ondes optique s'étendant entre la première section (17) de guide d'ondes optique et une troisième section (19) de guide d'ondes optique parmi les quatre sections (17 à 20) de guide d'ondes optique, la troisième section (19) de guide d'ondes optique s'étendant entre la deuxième section (18) de guide d'ondes optique et une quatrième section (20) de guide d'ondes optique parmi les quatre sections (17 à 20) de guide d'ondes optique, et la quatrième section (20) de guide d'ondes optique s'étendant entre la troisième section (19) de guide d'ondes optique et la première section (17) de guide d'ondes optique et comprend la deuxième face d'extrémité (24), et
l'axe longitudinal de la première section (17) de guide d'ondes optique étant orthogonal aux axes longitudinaux de la deuxième section (18) de guide d'ondes optique et de la quatrième section (20) de guide d'ondes optique, et étant parallèle à l'axe longitudinal de la troisième section (19) de guide d'ondes optique, et
la face d'extrémité (22) opposée à la première face d'extrémité (21) de la première section (17) de guide d'ondes optique étant inclinée de 45 degrés afin de réfléchir totalement vers la deuxième section (18) de guide d'ondes optique la lumière qui traverse la première section (17) de guide d'ondes optique le long de l'axe longitudinal de celle-ci, et, de manière correspondante, la lumière étant déviée de la deuxième section (18) de guide d'ondes optique vers la troisième section (19) de guide d'ondes optique par une face d'extrémité (23) de la deuxième section (18) de guide d'ondes optique inclinée de 45 degrés, et de manière correspondante, de la troisième section (19) de guide d'ondes optique vers la quatrième section (20) de guide d'ondes optique, par réflexion totale.

2. Guide d'ondes optique (5) selon la revendication 1, dans lequel le verre est un verre optique de type « flint ».

3. Guide d'ondes optique (5) selon l'une des revendications précédentes, dans lequel au moins une couche antireflet (31, 32) est disposée entre deux sections (17 à 20) de guide d'ondes optique qui sont fabriquées à partir de verres différents les uns des autres et qui présentent des indices de réfraction différents les uns des autres.

4. Guide d'ondes optique (5) selon l'une des revendications précédentes, comportant au moins une couche adhésive (33), grâce à laquelle deux sections (17 à 20) de guide d'ondes optique, fabriquées à partir de verres différents l'un de l'autre et présentant des indices de réfraction différents l'un de l'autre, sont assemblées l'une à l'autre par collage, la couche adhésive (33) présentant un indice de réfraction situé entre les indices de réfraction des deux sections (17 à 20) de guide d'ondes optique.

5. Capteur (1) de courant magnéto-optique destiné à détecter l'intensité d'un courant électrique dans un conducteur de courant (2), le capteur (1) de courant magnéto-optique comprenant au moins un guide d'ondes optique (5) selon l'une des revendications précédentes, ledit au moins un guide d'ondes optique étant conçu pour s'étendre de manière annulaire autour du conducteur de courant (2).
